# EUROPEAN PATENT SPECIFICATION

(11) **EP 3 327 729 B1**
(45) Date of publication and mention of the grant of the patent: **04.08.2021**
(21) Application number: 16827016.3
(22) Date of filing: 22.01.2016
(51) Int. Cl.: G21C 21/00, G21C 1/07, G21C 3/02, G21C 3/62, G21C 3/07, G21C 3/20, G21C 21/12, C23C 16/442, B01J 8/00

(54) **SYSTEM FOR CONTINUOUSLY PREPARING COATED PARTICLES IN LARGE SCALE**
SYSTEM ZUR KONTINUIERLICHEN HERSTELLUNG BESCHICHTETER PARTIKEL IN GROSSEM MASSSTAB
SYSTÈME DE PRÉPARATION CONTINUE DE PARTICULES ENROBÉES À GRANDE ÉCHELLE

(30) Priority: 23.07.2015 CN 201510438361
(43) Date of publication of application: 30.05.2018
(73) Proprietor: Tsinghua University, Beijing 100084 (CN)
(72) Inventor: LIU, Bing, Beijing 100084 (CN); SHAO, Youlin, Beijing 100084 (CN); LIU, Malin, Beijing 100084 (CN); LIU, Rongzheng, Beijing 100084 (CN); ZHU, Junguo, Beijing 100084 (CN); TANG, Yaping, Beijing 100084 (CN); ZHANG, Zuoyi, Beijing 100084 (CN)
(74) Representative: Kutzenberger Wolff & Partner
(86) International application number: PCT/CN2016/071785
(87) International publication number: WO 2017/012323

(56) References cited:
- EP-A1- 0 041 259
- WO-A1-2005/091306
- CN-A- 102 596 383
- CN-A- 102 760 503
- CN-A- 103 357 869
- CN-A- 105 139 897
- CN-U- 204 865 735
- DE-A1- 3 617 428
- JP-A- 2006 184 054
- US-A1- 2004 261 573

## Description

### FIELD OF TECHNOLOGY

The present disclosure relates to a preparation device of coated particles, and particularly to a system for continuously preparing coated particles in a large scale.

### BACKGROUND

The ceramic fuel element used in pebble-bed High Temperature Gas-Cooled Reactor (HTR) has a structure that tri-structural isotropic (TRISO) coated particles are dispersed in a graphite matrix of a fuel zone.

The first guarantee for the inherent safety of a HTR nuclear power plant is that the nuclear fuel is TRISO coated particles which consists of nuclear fuel core, loosened pyrolytic carbon layer, inner dense pyrolytic carbon layer, silicon carbide layer and outer dense pyrolytic carbon layer. Coated fuel particles are important part of a spherical fuel element of the HTR. Coated fuel particles can effectively prevent the release of fission products, so as to ensure an excellent safety of the HTR. The present disclosure is directed to the large-scale continuous preparation of coated fuel particles, which is related to the fields of nuclear fuel preparation and HTR.

Currently, the patents involving the preparation of coated fuel particles that have been published are mainly directed to the coating devices and auxiliary systems for batch production, such as patents CN 102 360 200 B and CN 103 357 869 B. Those patents are aiming at batch production, namely, single batch preparation, which has a time interval between two batches, wherein a temperature increase process and a temperature decrease process both exist, and is small in scale, does not completely break through laboratory research and cannot achieve real industrial continuous preparation. At the same time they fail to consider the productivity of coated particles and the economic characteristics of atomic cycle, i.e. the economy of coated fuel particles. Document DE 36 17 428 A1 discloses a system for preparing electrically conductive coated particles using a coating furnace, a cooling facility, a solid by-product treatment device, a cyclone, filters, a nozzle, a fluidization tube and a gas by-product device. Document EP 0 041 259 A1 is dedicated to a coating furnace and a process for production of nuclear fuel particles. Document WO 2005/ 091306 A1 discloses a process for nuclear particle coating.

### SUMMARY

The technical problem to be solved by the present disclosure is that a system in the prior art, aiming at batch production, namely, single batch preparation, has a time interval between two batches, and is small in scale, does not completely break through laboratory research and cannot achieve real industrial continuous preparation.

For this purpose, the present disclosure provides a system according to claim 1.

The coating furnace comprises a nozzle, a fluidization tube and a heating furnace;
the nozzle is connected with a fluidized bed of the fluidization tube, the fluidized bed is a multi-taper fluidized bed.

Optionally, the solid by-product treatment device comprises:
a cyclone separator, a first filter and a second filter that are connected in sequence;
the first filter is used for coarsely filtering solid by-products obtained by the cyclone separator, so as to obtain intermediate by-products;
the second filter is used for fine filtering the intermediate by-products obtained by the first filter.

Optionally, the gas by-product treatment device comprises:
a gas by-product temporary storage device, a gas by-product separation device and a gas by-product storage device;
the gas by-product temporary storage device is used for temporarily storing gas by-products of the solid by-product treatment device;
the gas by-product separation device is used for separating gas by-products temporarily stored in the gas by-product temporary storage device, so as to obtain at least hydrogen H₂ and argon Ar;
the gas by-product storage device is used for storing the hydrogen H₂ obtained by the gas by-product separation device.

According to the invention, the nozzle comprises: a middle hole, a plurality of primary loop holes and a plurality of secondary loop holes;
the plurality of primary loop holes are uniformly distributed around the middle hole;
the plurality of secondary loop holes are uniformly distributed around the middle hole;
the plurality of primary loop holes are arranged between the middle hole and the plurality of secondary loop holes.

Optionally, a gas distributor is provided in the fluidized bed;
the gas distributor comprises: a centre hole, a plurality of primary annular straight holes and a plurality of secondary annular slant holes;
the centre hole is on a same axis with the middle hole of the nozzle;
the plurality of primary annular straight holes are uniformly distributed around the centre hole;
the plurality of secondary annular slant holes are uniformly distributed around the centre hole;
the plurality of primary annular straight holes are arranged between the centre hole and the plurality of secondary annular slant holes.

Optionally, an axis of the middle hole and an axis of the nozzle are on a same plane, namely have no inclination.

Optionally, the primary loop holes and an axis of the nozzle are arranged on a same plane, namely have no inclination, or a 0 inclination.

Compared with the prior art, the system for continuously preparing coated particles in a large scale of the present disclosure solves the problem that the prior art aims at batch production, namely, single batch preparation, which has a time interval between two batches, wherein a temperature increase process and a temperature decrease process both exist, and is small in scale, does not completely break through laboratory research and cannot achieve real industrial continuous preparation.

### BRIEF DESCRIPTION OF THE DRAWINGS

FIG. 1 is a structure diagram of a system for continuously preparing coated particles in a large scale according to an embodiment of the present disclosure;
FIG. 2 is a connection diagram of a coating furnace and a cooling facility according to an embodiment of the present disclosure;
FIG. 3 is a structure diagram of a large-diameter coating furnace according to an embodiment of the present disclosure;
FIG. 4 is an A-A section view of a base of a large-diameter fluidization tube according to an embodiment of the present disclosure;
FIG.5 is a structure diagram of a solid by-product treating device according to an embodiment of the present disclosure;
FIG. 6 is a structure diagram of a gas by-product treating device according to an embodiment of the present disclosure.

### DETAILED DESCRIPTION

In order to more clearly explain the objectives, technical solutions, and advantages of the embodiments of the present disclosure, the technical solutions in the embodiments of the present disclosure will be described clearly hereinafter with reference to the accompanying drawings of the embodiments of the present disclosure. Apparently, the described embodiments are some but not all embodiments of the present disclosure. Based on the embodiments of the present disclosure, all other embodiments obtained by a person of ordinary skill in the art without creative work shall be within the protection scope of the present disclosure.

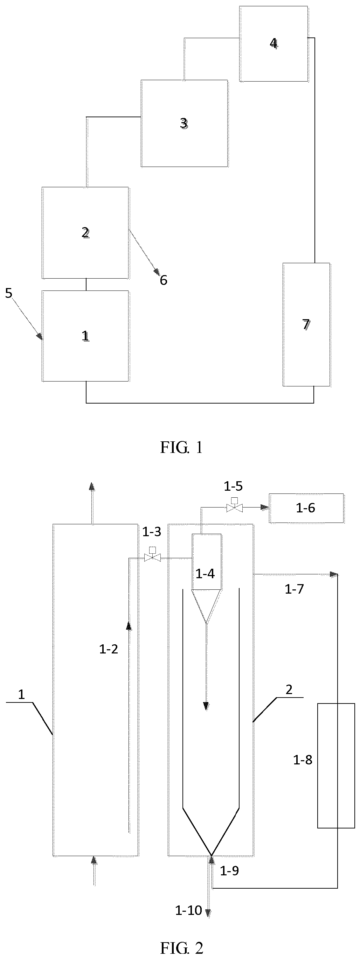

FIG.1 is a structure diagram of a system for continuously preparing coated particles in a large scale according to an embodiment, the system comprises: a coating furnace 1, a cooling facility 2, a solid by-product treating device 3, a gas by-product treating device 4 that are connected in sequence;
the coating furnace 1 is used for coating particles, wherein a fluidized-bed chemical vapor deposition method is used for coating process;
the cooling facility 2 is used for cooling coated particles;
the solid by-product treatment device 3 is used for treating solid by-products generated in the coating furnace during a particle coating process;
the gas by-product treatment device 4 is used for treating gas by-products generated in the coating furnace during the particle coating process.

In the present embodiment, the coating furnace 1 is provided with a feed port 5 of particles to be coated and the cooling facility 2 is provided with a discharge port 6 of the coated particles.

In the present embodiment, the system for continuously preparing coated particles in a large scale described above further comprises: a gas distribution device 7. An input end of the gas distribution device 7 is connected to the gas by-product treatment device 4; an output end of the gas distribution device 7 is connected to the coating furnace 1.

The coating furnace 1 in the system for continuously preparing coated particles in a large scale described above comprises: a nozzle, a fluidization tube and a heating furnace.

The nozzle is connected with a fluidized bed of the fluidization tube, and the fluidized bed is a multi-taper fluidized bed.

In a specific example, the solid by-product treatment device comprises:
a cyclone separator, a first filter and a second filter that are connected in sequence;
the first filter is used for coarsely filtering solid by-products obtained by the cyclone separator, so as to obtain intermediate by-products;
the second filter is used for fine filtering the intermediate by-products obtained by the first filter.

In a specific example, the gas by-product treatment device comprises:
a gas by-product temporary storage device, a gas by-product separation device and a gas by-product storage device;
the gas by-product temporary storage device is used for temporarily storing gas by-products of the solid by-product treatment device;
the gas by-product separation device is used for separating gas by-products temporarily stored in the gas by-product temporary storage device, so as to obtain at least hydrogen H₂ and argon Ar;
the gas by-product storage device is used for storing the hydrogen H₂ obtained by the gas by-product separation device.

The nozzle comprises a middle hole, a plurality of primary loop holes and a plurality of secondary loop holes;
the plurality of primary loop holes are uniformly distributed around the middle hole;
the plurality of secondary loop holes are uniformly distributed around the middle hole;
the plurality of primary loop holes are arranged between the middle hole and the plurality of secondary loop holes.

In a specific example, a gas distributor is provided in the fluidized bed;
the gas distributor comprises a centre hole, a plurality of primary annular straight holes and a plurality of secondary annular slant holes;
the centre hole is on a same axis with the middle hole of the nozzle;
the plurality of primary annular straight holes are uniformly distributed around the centre hole;
the plurality of secondary annular slant holes are uniformly distributed around the centre hole;
the plurality of primary annular straight holes are arranged between the centre hole and the plurality of secondary annular slant holes.

In a specific example, an axis of the middle hole and an axis of the nozzle are on a same plane, namely have no inclination;

In a specific example, the primary loop holes and the axis of the nozzle are on a same plane, namely have no inclination, or a 0 inclination.

The coating furnace of the system for continuously preparing coated particles in a large scale described above adopts a design of large-diameter fluidization tube, grading nozzle, gas distributor with multiple annular slant holes and fluidized bed with a bottom surface of multi tapers, therefore is able to continuously coat nuclear fuel particles.

The large-diameter fluidization tube of the system for continuously preparing coated particles in a large scale described above is a particle fluidization zone, with a diameter between 160mm-280mm.

The grading nozzle of the system for continuously preparing coated particles in a large scale described above is a middle loop multi-grading design, the middle is a single hole, the loop has 4-8 holes, and the characteristic is that they are uniformly distributed around the middle single hole.

The gas distributor with multiple annular slant holes of the system for continuously preparing coated particles in a large scale described above is a design of centre hole and annular slant holes, the centre hole is on a same axis with the middle hole of the nozzle described above, and the annular slant holes are in a periodic rotation distribution.

The bottom of the fluidized bed with a bottom surface of multi tapers of the system for continuously preparing coated particles in a large scale described above has a design of connected slopes with multiple angles, which helps reducing particle aggregation and increasing particle circulation speed.

The cooling facility of the system for continuously preparing coated particles in a large scale described above is a single hole spouted bed with an inner diameter between 160-250mm, and the material thereof is high-temperature resistant material, preferably ceramic material.

The gas by-product treatment device 4 of the system for continuously preparing coated particles in a large scale described above refers to a separation device for argon and hydrogen, it comprises an exhaust gas temporary storage tank, a gas freezing separation chamber and storage room.

The gas separation device of the system for continuously preparing coated particles in a large scale described above comprises two main parts of variable temperature adsorption and freezing separation.

The solid by-product treatment device 3 of the system for continuously preparing coated particles in a large scale described above comprises a three-level filtering device for online cyclone dust removal, online coarsely filtering and online fine filtering, and a by-product online storing replacement facility.

The by-product online storing replacement facility of the system for continuously preparing coated particles in a large scale described above is a design of two-stage gate valve container partition, which is able to replace storage container online without stopping gas-solid separation operation.

The fluidization gas refers to argon or hydrogen.

The flows of the fluidization and reaction gas are 200-400 L/min and 400-800 L/min respectively.

The coating temperature is between 1200-1600 Celsius degrees.

The ratio of the fluidization/reaction gas is between 1:1-10:1.

The liquid vapor temperature is between 35-55 Celsius degrees.

The flow of the gas carried by the liquid vapor is between 10-20L/min.

The system for continuously preparing coated particles in a large scale described above has functions as follows:
1) A vertical coating furnace coating function, with a design of enlarged diameter, grading nozzle, gas distributor with multiple annular slant holes/a bottom surface of multi tapers as the main feature.
2) A hot discharging function with hot particle transportation, hot gas-solid separation, transport pressure-balance device and coating furnace-cooling facility linkage operation as the main futures. The main body of a hot discharging system comprises an efficient cyclone separator and related piping and valves, wherein the hot discharging system overall is in the cooling facility and within a protection scope of inert gas.

The pressure balance of the hot discharging system is achieved by vacuum tank and secondary valve.

The control parameters of the middle process of the hot discharging include discharging temperature, discharging vacuum degree and cooling gas speed of the cooling facility;
the discharging temperature is between 600-1000 Celsius degrees;
the discharging vacuum degree is below -89 Kpa;
the cooling gas speed of the cooling facility is between 100-400 L/min.
3) A gas recycle function with multi-level online separation and cycling of fluidization gas, reaction gas and gas by-product as the main features.
4) A by-product online treating function with three-level filtering, online recycling and reusing of solid by-products as the main features.

The process parameters of the system for continuously preparing coated particles in a large scale described above include:
1) The process parameters of the coating process, i.e. the process parameters of feeding 6-10kg UO₂ for a single time, are specifically as follows: flow of fluidization/reaction gas, coating temperature, ratio of fluidization/reaction gas, and flow of gas carried by liquid. The present embodiment is only for illustrating, but does not limit the specific process parameters of the coating process.
2) The temperature rise and fall of continuous industrial production and the control parameters of the middle process of the hot discharging.

The beneficial effects of the present disclosure are: the present disclosure aims at the process of continuously preparing coated fuel particles in a large scale, which can achieve a real continuous production of coated particles, a control automation and an economic optimization of production, avoid manual operation errors, and reduce the possibility of accidents and equipment failure rate. The present disclosure has obvious economic value and social benefits.

FIG. 2 is connection diagram of the coating furnace and cooling facility according to an embodiment, wherein,
a hot feed tube 1-2 in the coating furnace 1 is connected with a feed adjusting valve 1-3;
the feed adjusting valve 1-3 is connected with a cyclone separator 1-4 in the cooling facility 2;
the cyclone separator 1-4 is connected with a vacuum adjusting valve 1-5;
the vacuum adjusting valve 1-5 is connected with a vacuum generating cavity 1-6;
an air outlet 1-7 of the cooling facility 2 is connected with a gas cooler 1-8 of the cooling facility 2;
the gas cooler 1-8 is connected with an air inlet 1-9 of the cooling facility 2;
1-10 refers to a discharge port of the cooling facility 2.

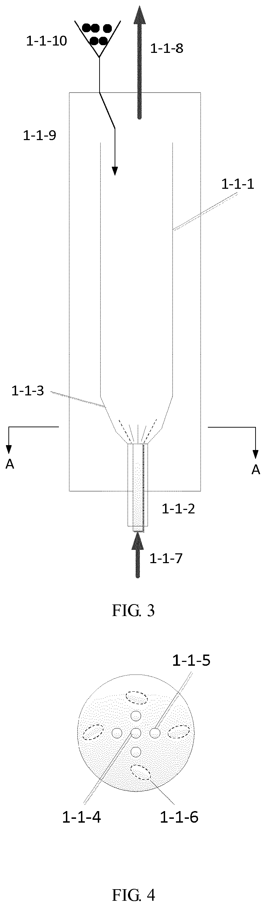

FIG. 3 is a structure diagram of a large-diameter coating furnace according to an embodiment, the large-diameter coating furnace comprises: a large-diameter fluidization tube 1-1-1 and nozzle 1-1-2;
wherein the base 1-1-3 of the large-diameter fluidization tube 1-1-1 has a double-taper design; the nozzle 1-1-2 is designed as a middle loop.

FIG. 4 is an A-A section view of a base of a large-diameter fluidization tube according to an embodiment, wherein,
a centre hole 1-1-4, straight holes 1-1-5 and slant holes 1-1-6 for ventilation is provided on the base 1-1-3; in the present embodiment, four straight holes 1-1-5 are arranged around the centre hole 1-1-4, four slant holes 1-1-6 are arranged on peripheries of the four straight holes 1-1-5, the numbers of the straight holes and slant holes in the present embodiment are only for illustrating, the present embodiment does not limit the number of the straight holes and slant holes.

In the present embodiment, gas enters into the coating furnace in the direction indicated by arrow 1-1-7 and leaves the coating furnace in the direction indicated by arrow 1-1-8;
1-1-9 refers to a coating furnace heating pipe and housing; 1-1-10 refers to a coating furnace particle feed port.

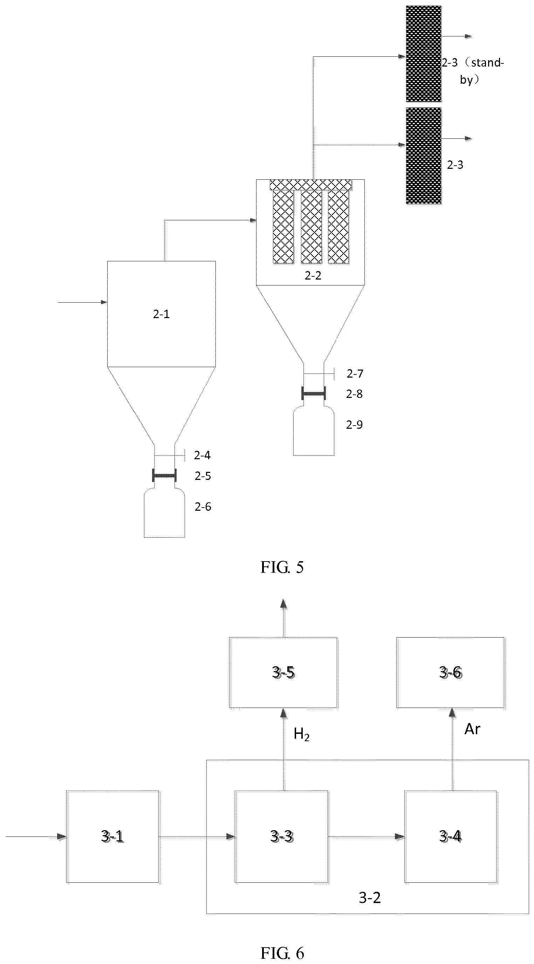

FIG.5 is a structure diagram of a solid by-product treating device according to an embodiment, the solid by-product treating device comprises:
a primary cyclone separator 2-1 for the first separation of solid by-products generated by the coating furnace during coating particles;
a secondary bag filter 2-2 for the second separation of the solid by-products after the first separation;
a tertiary fine filter 2-3, for the fine filtering of the solid by-products after the second separation;
a first gate valve 2-4, a first fast interface 2-5 and a first waste tank 2-6; a second gate valve 2-7, a second fast interface 2-8 and a second waste tank 2-9.

FIG. 6 is a structure diagram of a gas by-product treating device according to an embodiment, the gas by-product treating device comprises:
an exhaust high-pressure temporary container 3-1 and a gas separation chamber 3-2;
wherein the gas separation chamber 3-2 comprises a pressure swing absorber 3-3 and a cryogenic separator 3-4;
the gas by-product treating device further comprises: hydrogen H₂ secondary storage and redistribution device 3-5; argon Ar recycling system 3-6.

Particles are coated by the system for continuously preparing coated particles in a large scale described above as follows:
particles to be coated are added to the coating furnace, coating gas and fluidizing gas are introduced, meanwhile gas by-products and solid by-products are collected; after the coating is completed, the fluidizing gas is kept unchanged and the temperature is reduced to a suitable temperature (the suitable temperature may be preset), a discharge tube is inserted, the speed of fluidization gas in the cooling facility is set and the discharge vacuum is adjusted, the particles are absorbed into the cooling facility by opening a discharge valve until all particles are absorbed; then the particles to be coated are again added to the coating furnace for the next coating.

After coating particles are completed by the system for continuously preparing coated particles in a large scale, the system is used in the real coating process of coated nuclear fuel particles, so as to further clarify the coating effect of particles.

The flow of the fluidization gas of the coating furnace is set to be 400L/min, the flow of coating gas is set to be 200L/min, the amount of charged particles is set to be 10kg, the flow of cooling gas is set to be 90L/min, the discharge vacuum is set to be -90Kpa, the discharge temperature is set to be 950 Celsius degrees, the discharge valve and vacuum valve are adjusted after the coating is completed so as to complete a whole coating-cooling process. The coating parameters can satisfy the design requirements, and there is no particle found to be squeezed or crushed.

### INDUSTRIAL APPLICABILITY

The present disclosure aims at the process of continuously preparing coated fuel particles in a large scale, which can achieve a real continuous production of coated particles, a control automation and an economic optimization of production, avoid manual operation errors, and reduce the possibility of accidents and equipment failure rate. The present disclosure has obvious economic value and social benefits, and has strong industrial applicability.

## Claims

1. A system for continuously preparing coated fuel particles for use in High Temperature Gas-Cooled Reactors in a large scale, comprising:
a coating furnace, a cooling facility, a solid by-product treating device and a gas by-product treating device that are connected in sequence;
the coating furnace is usable for coating particles;
the cooling facility is usable for cooling coated particles; the solid by-product treatment device is usable for treating solid by-products generated in the coating furnace during a particle coating process;
the gas by-product treatment device is usable for treating gas by-products generated in the coating furnace during the particle coating process, **characterized in that** the coating furnace comprises a nozzle, a fluidization tube and a heating furnace, wherein the nozzle is connected with a fluidized bed of the fluidization tube, and the fluidized bed is a multi-taper fluidized bed;
wherein the nozzle comprises: a middle hole, a plurality of primary loop holes and a plurality of secondary loop holes, wherein, the plurality of primary loop holes are uniformly distributed around the middle hole;
wherein the plurality of secondary loop holes are uniformly distributed around the middle hole; and
wherein the plurality of primary loop holes are arranged between the middle hole and the plurality of secondary loop holes.

2. The system of claim 1, **characterized in that**, the solid by-product treatment device comprises:
a cyclone separator, a first filter and a second filter that are connected in sequence;
the first filter is for coarsely filtering solid by-products obtained by the cyclone separator, so as to obtain intermediate by-products;
the second filter is for fine filtering the intermediate by-products obtained by the first filter.

3. The system of claim 1, **characterized in that**, the gas by-product treatment device comprises:
a gas by-product temporary storage device, a gas by-product separation device and a gas by-product storage device;
the gas by-product temporary storage device is for temporarily storing gas by-products of the solid by-product treatment device;
the gas by-product separation device is for separating gas by-products temporarily stored in the gas by-product temporary storage device, so as to obtain at least hydrogen H₂ and argon Ar;
the gas by-product storage device is for storing the hydrogen H₂ obtained by the gas by-product separation device.

4. The system of claim 1, **characterized in that**, a gas distributor is provided in the fluidized bed;
the gas distributor comprises: a centre hole, a plurality of primary annular straight holes and a plurality of secondary annular slant holes;
the centre hole is on a same axis with the middle hole of the nozzle;
the plurality of primary annular straight holes are uniformly distributed around the centre hole;
the plurality of secondary annular slant holes are uniformly distributed around the centre hole; and
the plurality of primary annular straight holes are arranged between the centre hole and the plurality of secondary annular slant holes.

5. The system of claim 1, **characterized in that**, an axis of the middle hole and an axis of the nozzle are on a same plane, namely have no inclination.

6. The system of claim 1, **characterized in that**, the primary loop holes and an axis of the nozzle are on a same plane, namely have no inclination, or a 0 inclination.

## Patentansprüche

1. System zum kontinuierlichen Herstellen beschichteter Brennstoffpartikel zur Verwendung in gasgekühlten Hochtemperaturreaktoren im großen Maßstab, Folgendes umfassend:
einen Beschichtungsofen, eine Kühlanlage, eine Behandlungsvorrichtung für festes Nebenprodukt und eine Behandlungsvorrichtung für gasförmiges Nebenprodukt, die nacheinander verbunden sind;
wobei der Beschichtungsofen zum Beschichten von Partikeln verwendbar ist;
wobei die Kühlanlage zum Kühlen beschichteter Partikel verwendbar ist;
wobei die Behandlungsvorrichtung für festes Nebenprodukt zum Behandeln fester Nebenprodukte verwendbar ist, die in dem Beschichtungsofen während eines Partikelbeschichtungsprozesses erzeugt werden;
wobei die Behandlungsvorrichtung für gasförmiges Nebenprodukt zum Behandeln gasförmiger Nebenprodukte verwendbar ist, die in dem Beschichtungsofen während des Partikelbeschichtungsprozesses erzeugt werden,
**dadurch gekennzeichnet, dass**
der Beschichtungsofen eine Düse, ein Fluidisierrohr und einen Heizofen umfasst, wobei die Düse mit einem Fließbett des Fluidisierrohrs verbunden ist und das Fließbett ein mehrfach abgeschrägtes Fließbett ist;
wobei die Düse Folgendes umfasst: eine Mittelöffnung, mehrere Primärkreisöffnungen und mehrere Sekundärkreisöffnungen, wobei die mehreren Primärkreisöffnungen gleichmäßig um die Mittelöffnung herum verteilt sind;
wobei die mehreren Sekundärkreisöffnungen gleichmäßig um die Mittelöffnung herum verteilt sind; und
wobei die mehreren Primärkreisöffnungen zwischen der Mittelöffnung und den mehreren Sekundärkreisöffnungen angeordnet sind.

2. System nach Anspruch 1, **dadurch gekennzeichnet, dass**, die Behandlungsvorrichtung für festes Nebenprodukt Folgendes umfasst:
eine Wirbelkammer, einen ersten Filter und einen zweiten Filter, die nacheinander verbunden sind;
wobei der erste Filter zum groben Filtern fester Nebenprodukte dient, die durch die Wirbelkammer erhalten werden, um so Zwischennebenprodukte zu erhalten;
wobei der zweite Filter zum feinen Filtern der Zwischennebenprodukte dient, die durch den ersten Filter erhalten werden.

3. System nach Anspruch 1, **dadurch gekennzeichnet, dass**, die Behandlungsvorrichtung für gasförmiges Nebenprodukt Folgendes umfasst:
eine temporäre Speichervorrichtung für gasförmiges Nebenprodukt, eine Abtrennvorrichtung für gasförmiges Nebenprodukt und eine Speichervorrichtung für gasförmiges Nebenprodukt;
wobei die temporäre Speichervorrichtung für gasförmiges Nebenprodukt zum vorübergehenden Speichern von gasförmigen Nebenprodukten der Behandlungsvorrichtung für festes Nebenprodukt dient;
wobei die Abtrennvorrichtung für gasförmiges Nebenprodukt zum Abtrennen von gasförmigen Nebenprodukten dient, die vorübergehend in der temporären Speichervorrichtung für gasförmiges Nebenprodukt gespeichert sind, um so mindestens Wasserstoff H₂ und Argon Ar zu erhalten;
wobei die Speichervorrichtung für gasförmiges Nebenprodukt zum Speichern des Wasserstoffs H₂ dient, der durch die Abtrennvorrichtung für gasförmiges Nebenprodukt erhalten wurde.

4. System nach Anspruch 1, **dadurch gekennzeichnet, dass** in dem Fließbett ein Gasverteiler bereitgestellt ist;
der Gasverteiler Folgendes umfasst: eine Mittelöffnung, mehrere primäre ringförmige gerade Öffnungen und mehrere sekundäre ringförmige schräge Öffnungen;
die Mittelöffnung auf einer gleichen Achse mit der Mittelöffnung der Düse ist;
die mehreren primären ringförmigen geraden Öffnungen gleichmäßig um die Mittelöffnung herum verteilt sind;
die mehreren sekundären ringförmigen schrägen Öffnungen gleichmäßig um die Mittelöffnung herum verteilt sind; und
die mehreren primären ringförmigen geraden Öffnungen zwischen der Mittelöffnung und den mehreren sekundären ringförmigen schrägen Öffnungen angeordnet sind.

5. System nach Anspruch 1, **dadurch gekennzeichnet, dass**, eine Achse der Mittelöffnung und eine Achse der Düse auf einer gleichen Ebene sind, die namentlich keine Neigung aufweist.

6. System nach Anspruch 1, **dadurch gekennzeichnet, dass** die Primärkreisöffnungen und eine Achse der Düse auf einer gleichen Ebene sind, die namentlich keine Neigung oder eine Neigung von 0 aufweist.

## Revendications

1. Système de préparation continue à grande échelle de particules de combustible enrobées à utiliser dans des réacteurs à haute température refroidis au gaz, comprenant :
un four d'enrobage, une installation de refroidissement, un dispositif de traitement de sous-produits solides et un dispositif de traitement de sous-produits gazeux qui sont reliés en séquence ;
le four d'enrobage est utilisable pour enrober des particules ;
l'installation de refroidissement est utilisable pour refroidir des particules enrobées ;
le dispositif de traitement de sous-produits solides est utilisable pour traiter des sous-produits solides générés dans le four d'enrobage pendant un procédé d'enrobage de particules ;
le dispositif de traitement de sous-produits gazeux est utilisable pour traiter des sous-produits gazeux générés dans le four d'enrobage pendant le procédé d'enrobage de particules,
**caractérisé en ce que**
le four d'enrobage comprenant une buse, un tube de fluidisation et un four de chauffage, la buse étant reliée à un lit fluidisé du tube de fluidisation, et le lit fluidisé étant un lit fluidisé à rétrécissements multiples ;
dans lequel la buse comprend : un trou médian, une pluralité de trous de boucle primaire et une pluralité de trous de boucle secondaire, la pluralité de trous de boucle primaire étant répartis uniformément autour du trou médian ;
dans lequel la pluralité de trous de boucle secondaire sont répartis uniformément autour du trou médian ; et
dans lequel la pluralité de trous de boucle primaire sont disposés entre le trou médian et la pluralité de trous de boucle secondaire.

2. Système de la revendication 1, **caractérisé en ce que** le dispositif de traitement de sous-produits solides comprend :
un séparateur cyclonique, un premier filtre et un deuxième filtre qui sont reliés en séquence ;
le premier filtre sert à filtrer grossièrement des sous-produits solides obtenus par le séparateur cyclonique, de manière à obtenir des sous-produits intermédiaires ;
le deuxième filtre sert à filtrer finement les sous-produits intermédiaires obtenus par le premier filtre.

3. Système de la revendication 1, **caractérisé en ce que** le dispositif de traitement de sous-produits gazeux comprend :
un dispositif de stockage temporaire de sous-produits gazeux, un dispositif de séparation de sous-produits gazeux et un dispositif de stockage de sous-produits gazeux ;
le dispositif de stockage temporaire de sous-produits gazeux sert à stocker temporairement des sous-produits gazeux du dispositif de traitement de sous-produits solides ;
le dispositif de séparation de sous-produits gazeux sert à séparer des sous-produits gazeux temporairement stockés dans le dispositif de stockage temporaire de sous-produits gazeux, de manière à obtenir au moins de l'hydrogène H₂ et de l'argon Ar ;
le dispositif de stockage de sous-produits gazeux sert à stocker l'hydrogène H₂ obtenu par le dispositif de séparation de sous-produits gazeux.

4. Système de la revendication 1, **caractérisé en ce qu'**un distributeur de gaz est disposé dans le lit fluidisé ;
le distributeur de gaz comprend : un trou central, une pluralité de trous primaires annulaires droits et une pluralité de trous secondaires annulaires inclinés ;
le trou central est sur un même axe que le trou médian de la buse ;
la pluralité de trous primaires annulaires droits sont répartis uniformément autour du trou central ;
la pluralité de trous secondaires annulaires inclinés sont répartis uniformément autour du trou central ; et
la pluralité de trous primaires annulaires droits sont disposés entre le trou central et la pluralité de trous secondaires annulaires inclinés.

5. Système de la revendication 1, **caractérisé en ce qu'**un axe du trou médian et un axe de la buse sont sur un même plan, autrement dit n'ont aucune inclinaison.

6. Système de la revendication 1, **caractérisé en ce que** les trous de boucle primaire et un axe de la buse sont sur un même plan, autrement dit n'ont aucune inclinaison, ou une inclinaison nulle.
